(19) Europäisches Patentamt
European Patent Office
Office européen des brevets

(11) EP 3 258 511 A1

(12) **EUROPEAN PATENT APPLICATION**

(43) Date of publication:
**20.12.2017 Bulletin 2017/51**

(21) Application number: **16174446.1**

(22) Date of filing: **14.06.2016**

(51) Int Cl.:
***H01L 51/05*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Solvay SA**
**1120 Bruxelles (BE)**

(72) Inventors:
- **FENOLL, Mathieu**
  **3078 Everberg (BE)**
- **VAN BEVEREN, Maxime**
  **6032 Mont-Sur-Marchienne (BE)**

(54) **ORGANIC SEMICONDUCTOR COMPOSITION AND SEMICONDUCTING LAYER OBTAINED THEREFROM**

(57) The present invention concerns a composition comprising at least one crystalline organic semiconductor and at least one triarylamine of formula

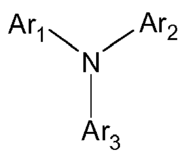

provided at least one of $Ar_1$, $Ar_2$ and $Ar_3$ comprises at least two fused aromatic rings.

EP 3 258 511 A1

## Description

The present invention concerns an organic semiconductor (OSC) composition comprising a crystalline semiconductor and a triarylamine and the use thereof for the manufacture of an organic semiconducting layer suitable for the manufacture of an organic electronic device.

Organic semiconducting layers have been the object of many attentions in the field of organic electronics. Especially when low cost organic electronics devices are targeted, one needs cheap material, easy processes and high cadences to produce the devices. Process to manufacture organic semiconducting thin layers may involve deposition under vacuum or may involve a solution process like ink printing. Liquid coating of organic semiconductor composition is generally preferred over vacuum deposition techniques. The use of crystalline semiconductor such as TIPS-pentacene alone in a semiconducting layer may require drastic conditions and long times to promote convenient crystallization both being detrimental to manufacture with high cadences. Moreover, crystallization of any crystalline OSC alone is such a sensitive process that reproducibility may be impaired by minor changes during manufacturing.

US2009302310 relates to the use of a triarylamine as the organic semiconductor material contained in an organic semiconducting layer comprised between a source and a drain of an OFET. Among many triarylamines, N4,N4'-di(naphthalen-1-yl)-N4,N4'-diphenylbiphenyl-4,4'-diamine (NPD) is cited. Moreover, the association of NPD with any other organic semiconductor, crystalline or amorphous, is neither disclosed nor suggested in US'310.

WO2014/008971 discloses the manufacture of a semiconducting layer comprising an organic semiconductor and an organic binder. The objective is to enhance the adhesion of the semiconducting layer with parylene which is used as the dielectric layer of an OFET. An organic semiconductor formulation of WO'971 comprises a triarylamine small molecule organic binder, N4,N4'-diphenyl-N4,N4'-dim-tolylbiphenyl-4,4'-diamine (TPD) and a crystalline organic semiconductor, namely 2, 8-Difluoro-5, 11-bis(triethylsilylethynyl)anthradithiophene (DiF-TES-ADT) dissolved in cyclohexylbenzene : mesitylene(80:20). Nothing is in WO'971 taught neither about the reproducibility of field effect mobility measurements nor about bias stress stability.

There is a need for a new organic semiconductor composition suitable for preparing a semiconducting layer of an electronic device having reproducible properties, in particular reproducible high field effect mobility.

There is also a need for an organic semiconducting layer having high stability and, more particularly, bias stress stability.

There is also a need for an organic semiconductor composition suitable for preparing semiconducting layer having high field effect mobility, low cost and easy processing.

The above described needs and still other ones, are advantageously met by composition comprising at least one crystalline organic semiconductor and at least one triarylamine of formula 1

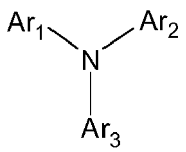

1

wherein

each of $Ar_1$, $Ar_2$ and $Ar_3$ independently represents an optionally substituted aryl or an optionally substituted heteroaryl group,

provided at least one of $Ar_1$, $Ar_2$ and $Ar_3$ comprises at least two fused aromatic or heteroaromatic rings.

By aryl or heteroaryl group derived from a compound comprising at least one aromatic or heteroaromatic ring, is meant an aryl or heteroaryl group that can be obtained by the removal of one hydrogen atom from the aromatic or heteroaromatic ring of the compound. For example, 1-naphtyl can be obtained by removing the hydrogen atom in the position 1 of naphthalene. Thus in the meaning of the present invention, 1-naphthyl is an aryl group derived from naphthalene. Similarly, 5-quinolyl can be obtained by removing the hydrogen atom in the position 5 of quinoline. Thus in the meaning of the present invention, 5-quinolyl is a heteroaryl group derived from quinoline.

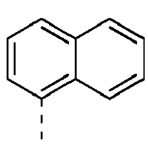

1-naphthyl

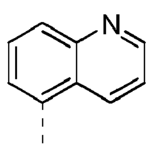

5-quinolyl

When any of $Ar_1$, $Ar_2$ and $Ar_3$ is a substituted aryl or a substituted heteroaryl group, one has to understand that it is substituted by one or more X substituent group(s), identical or different on each occurrence. X is generally selected from the list consisting of alkyl, heteroalkyl, cycloalkyl, alkylaryl, aryl, heteroaryl groups comprising 1-24 carbon atoms, $-NR_1R_2$, $-O-R_3$, $-SR_4$ and $-P\ R_5R_6$, wherein $R_1$, $R_2$, $R_3$, $R_4$, $R_5$ and $R_6$, which may be the same or different, represent a $C_5$ to $C_{24}$ aryl or a $C_4$ to $C_{24}$ heteroaryl group, which may itself be optionally substituted by one or more Y substituent group(s), identical or different on each occurrence. Y is selected from the list consisting of alkyl, heteroalkyl, cycloalkyl, aryl, heteroaryl groups comprising 1-24 carbon atoms, $-NR_7R_8$, $-O-R_9$, $-SR_{10}$ and $-P\ R_{11}R_{12}$, wherein $R_7$, $R_8$, $R_9$, $R_{10}$, which may be the same or different, represent a $C_5$ to $C_{24}$ aryl or a $C_4$ to $C_{24}$ heteroaryl group. The alkyl and heteroalkyl groups may be linear, branched or cyclic. The term heteroalkyl as used herein refers to an alkyl group wherein one or more of the carbon atom(s) of the alkyl group is (are) replaced by a heteroatom, such as Si, S, N or O. Examples of heteroalkyl groups include, but are not limited to, alkoxy, alkyl substituted by cyano group, alkyl substituted by trialkyl silyl group.

**The at least one of $Ar_1$, $Ar_2$ and $Ar_3$ groups which comprises at least two fused aromatic or heteroaromatic rings.**

The at least one of $Ar_1$, $Ar_2$ and $Ar_3$ groups which comprises at least two fused aromatic or heteroaromatic rings is generally derived from a compound selected from compounds of following formulae:

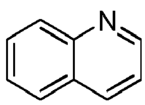
quinoline
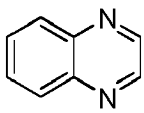
quinoxaline
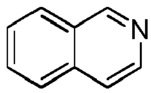
isoquinoline
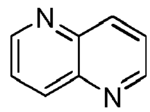
1,5-naphthyridine
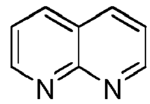
1,8-naphthyridine

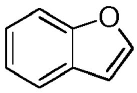
benzofuran
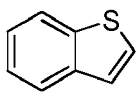
benzo[*b*]thiophene
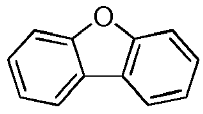
dibenzo[*b*,*d*]furan
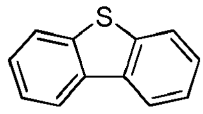
dibenzo[*b*,*d*]thiophene

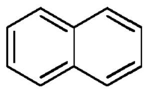
naphthalene
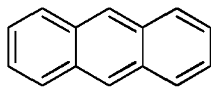
anthracene
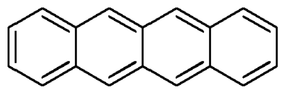
tetracene

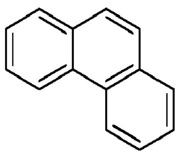
phenanthrene
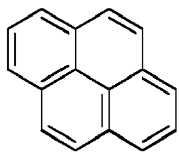
pyrene
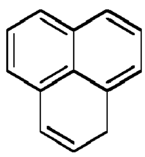
1*H*-phenalene
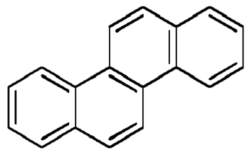
chrysene

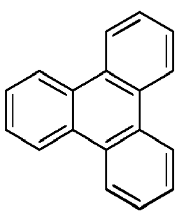
triphenylene
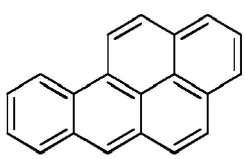
benzo[*pqr*]tetraphene
and
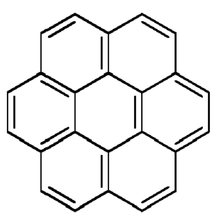
coronene
,

which compounds may be substituted or unsubstituted.

Advantageously, the at least one of $Ar_1$, $Ar_2$ and $Ar_3$ which comprises at least two fused aromatic rings is derived from a compound selected from naphthalene, anthracene, tetracene, phenanthrene, pyrene, 1H-phenalene, chrysene, triphenylene, benzo[pqr]tetraphene and coronene, which compounds may substituted or unsubstituted.

Preferably, it is derived from a substituted or unsubstituted naphthalene group.

More preferably, it is derived from unsubstituted naphthalene group.

Even more preferably, it is 1-naphtyl.

In certain embodiments, each of $Ar_1$, $Ar_2$ and $Ar_3$ comprise at least two fused aromatic rings. Preferably, at most two of $Ar_1$, $Ar_2$ and $Ar_3$ comprise at least two fused aromatic or heteroaromatic rings. More preferably, one and only one among $Ar_1$, $Ar_2$ and $Ar_3$ comprises at least two fused aromatic or heteroaromatic rings.

**$Ar_1$, $Ar_2$ and $Ar_3$ groups which do not comprise at least two fused aromatic or heteroaromatic rings, if any.**

Generally, any group from $Ar_1$, $Ar_2$ and $Ar_3$ which does not comprise at least two fused aromatic or heteroaromatic rings, is an optionally substituted aryl or an optionally substituted heteroaryl group, which is derived from a compound selected from compounds C* of the following formulae:

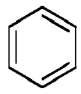
benzene

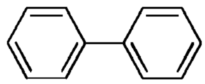
biphenyl

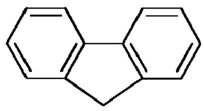
9*H*-fluorene

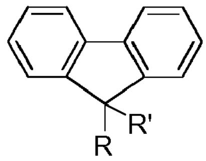
9-R-9-R'-9*H*-fluorene

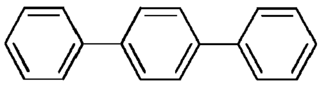

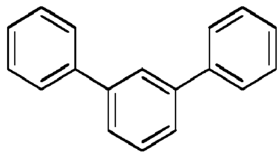

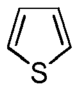
thiophene

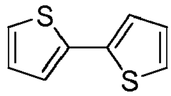
2,2'-bithiophene

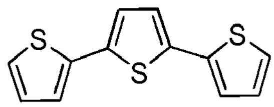

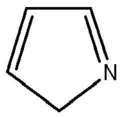
2*H*-pyrrole

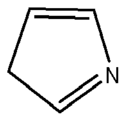
3*H*-pyrrole

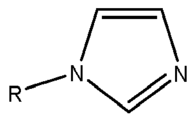
1-substituted 1*H*-imidazole

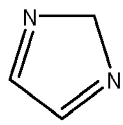
2H-imidazole

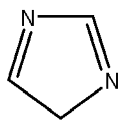
4*H*-imidazole

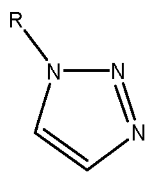
1-substituted-1*H*-1,2,3-triazole

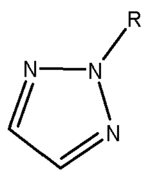
2-substituted-2H-1,2,3-triazole

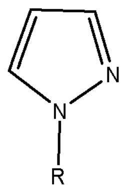
1-substituted-1*H*-pyrazole

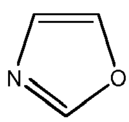
oxazole

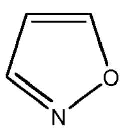
isoxazole

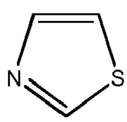
thiazole

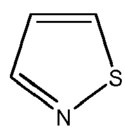
isothiazole

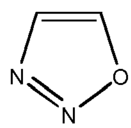
1,2,3-oxadiazole

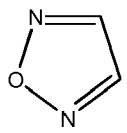
1,2,5-oxadiazole

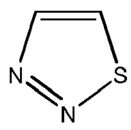
1,2,3-thiadiazole

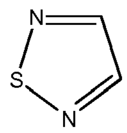
1,2,5-thiadiazole

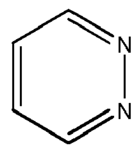
pyridazine

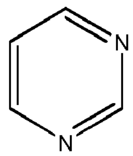
pyrimidine

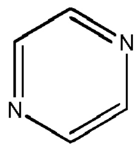
pyrazine

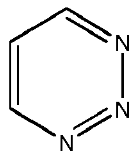
1,2,3-triazine

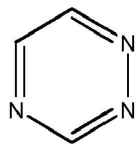
1,2,4-triazine

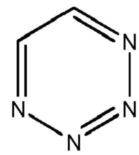
1,2,3,4-tetrazine

wherein R and R' represents a $C_1$-$C_{24}$ hydrocarbyl or heterohydrocarbyl group and wherein R and R' cannot be involved in a same cyclic moiety, and wherein compounds C* may be substituted or unsubstituted.

The term "hydrocarbyl" as used herein refers to a group only containing carbon and hydrogen atoms. The hydrocarbyl group may be saturated or unsaturated, linear, branched or cyclic. If the hydrocarbyl is cyclic, the cyclic group may be an aromatic or non-aromatic group.

The term "heterohydrocarbyl" as used herein refers to a hydrocarbyl group wherein one or more of the carbon atoms is/are replaced by a heteroatom, such as Si, S, N or O. Included within this definition are heteraromatic rings, i.e. wherein one or more carbon atom within the ring structure of an aromatic ring is replaced by a heteroatom.

Any group from $Ar_1$, $Ar_2$ and $Ar_3$ which does not comprise at least two fused aromatic or heteroaromatic rings is preferably an optionally substituted aryl group. More preferably, it is an optionally substituted aryl group derived from compounds selected from benzene, biphenyl, 9H-fluorene and 9-R-9-R'-9H-fluorene, which compounds may be substituted or unsubstituted. Even more preferably, it is an optionally substituted aryl group derived from compounds selected benzene, biphenyl and 9-R-9-R'-9H-fluorene, wherein R and R' have the same structure as previously described, which compounds may be substituted or unsubstituted.

**Embodiment E1**

In a preferred embodiment E1, $Ar_1$ and only $Ar_1$, is 1-naphtyl group. The formula A below is a representation of the triarylamine according to the preferred embodiment E1:

A :

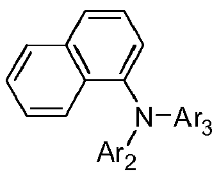

wherein each of $Ar_2$ and $Ar_3$ independently represents an optionally substituted aryl or an optionally substituted heteroaryl group which does not comprise at least two fused aromatic or heteroaromatic rings, as described above.

**Embodiment E2**

In a preferred embodiment E2, $Ar_2$ and only $Ar_2$, is a biphenyl-4-yl which is substituted with one or more substituent(s) X as previously defined.

$Ar_2$ is preferably

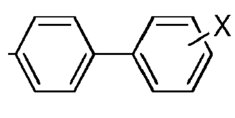

wherein X substituent group is as previously defined.

$Ar_2$ is more preferably substituted in the 4' position only

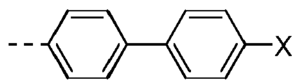

wherein X substituent group is as previously defined; the case being, a representation of the triarylamine according to the preferred embodiment E2 is provided by formula B:

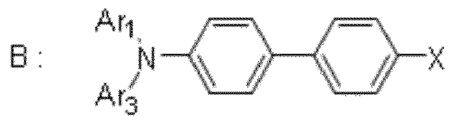

wherein, each of $Ar_1$ and $Ar_3$ independently represents an optionally substituted aryl or an optionally substituted heteroaryl group as previously described, provided at least one of $Ar_1$ and $Ar_3$ comprises at least two fused aromatic or heteroaromatic rings as previously described, and X is as previously defined.

**Embodiment E3**

In another preferred embodiment E3, $Ar_2$ and only $Ar_2$, is a 9-R-9-R'-9H-fluorene-2-yl which is substituted with one or more substituent(s) X, with R, R' and X as previously defined.

$Ar_2$ is preferably

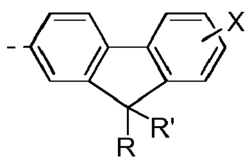

wherein X substituent group is as previously defined.

$Ar_2$ is more preferably substituted in the 7 position only

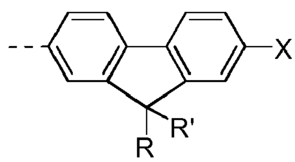

wherein X substituent group is as previously defined; the case being, a representation of the triarylamine according to the preferred embodiment E3 is provided by formula C:

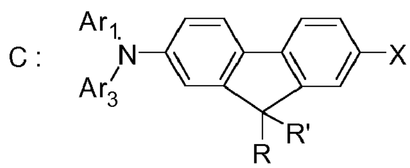

wherein, each of $Ar_1$ and $Ar_3$ independently represents an optionally substituted aryl or an optionally substituted heteroaryl group as previously described, provided at least one of $Ar_1$ and $Ar_3$ comprises at least two fused aromatic or heteroaromatic rings as previously described, and X is as previously defined.

**Embodiment E4**

In a further preferred embodiment E4, $Ar_1$ and only $Ar_1$, is 1-naphtyl group and, $Ar_2$ and only $Ar_2$, is a biphenyl-4-yl which is substituted with one or more substituent(s) X as previously defined.

Preferably, in embodiment E4, $Ar_2$ is a substituted biphenyl-4-yl which is substituted with a substituent X in the

4’ position only.

More preferably, in embodiment E4, the triarylamine is represented by formula D:

D : 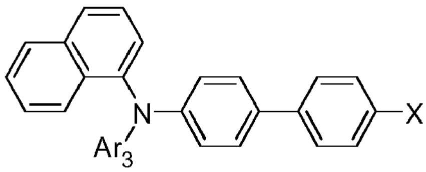

wherein:

- X group is as depicted above and
- $Ar_3$ represents either an optionally substituted aryl or optionally substituted heteroaryl group which comprises at least two fused aromatic or heteroaromatic rings as previously described, or an optionally substituted aryl or optionally substituted heteroaryl group which does not comprise at least two fused aromatic or heteroaromatic rings as also previously described.

**Embodiment E5**

In another preferred embodiment E5, $Ar_1$ and only $Ar_1$, is 1-naphtyl and, $Ar_2$ and only $Ar_2$, is a 9-R-9-R’-9H-fluorene-2-yl group substituted with one or more substituent(s) X, with R, R’ and X as above defined.

$Ar_2$ is preferably a 9-R-9-R’-9H-fluorene-2-yl group which is substituted with a substituent X in the 7 position only, with R, R’ and X as above defined.

More preferably, in embodiment E5, the triarylamine is represented by the formula E

E : 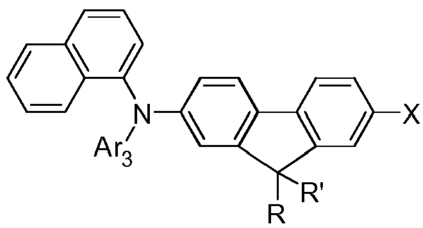

wherein:

- $Ar_3$ represents an optionally substituted aryl or an optionally substituted heteroaryl group as previously described , that may comprises at least two fused aromatic or heteroaromatic rings as previously described, and
- R, R’ and X group are as depicted above.

**Embodiment E6**

In a preferred embodiment E6, $Ar_1$ and only $Ar_1$, is 1-naphtyl group, $Ar_2$ and only $Ar_2$, is a substituted biphenyl-4-yl substituted with one or more substituent(s) X as above defined.

$Ar_2$, is preferably a biphenyl-4-yl which is substituted with a substituent X in the 4’ position only, with X as above defined.

Preferably, in embodiment E6, $Ar_3$ is a phenyl group optionally substituted by $C_{1-20}$ alkyl or heteroalkyl group. The $C_{1-20}$ alkyl or heteroalkyl group may be linear, branched or cyclic.

More preferably, in embodiment E6, the triarylamine is represented by the formula F

F :

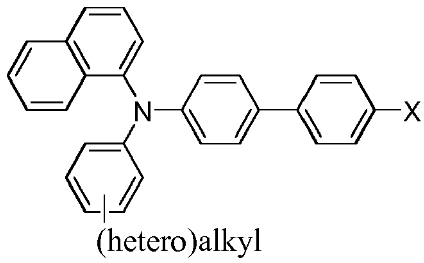

wherein X group is as depicted above.

**Embodiment E7:**

In a preferred embodiment E7, $Ar_1$ and only $Ar_1$, is 1-naphtyl group, $Ar_2$ and only $Ar_2$, is a substituted 9-R-9-R'-9H-fluorene-2-yl substituted with one or more substituent(s) X, with R, R' and X as above defined.

$Ar_2$, is preferably a 9-R-9-R'-9H-fluorene-2-yl which is substituted with a substituent X in the 7 position only, with R, R' and X as above defined.

Preferably, in embodiment E7, $Ar_3$ is a phenyl group optionally substituted by $C_{1-20}$ alkyl or heteroalkyl group. The $C_{1-20}$ alkyl or heteroalkyl group may be linear, branched or cyclic.

More preferably, in embodiment E7, the triarylamine is represented by the formula G

G :

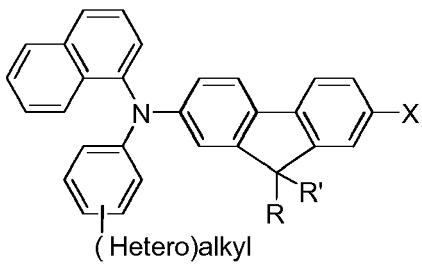

wherein X group is as depicted above.

**Embodiment E8**

In a preferred embodiment E8, the triarylamine is one in accordance with any one of the embodiments E2, E3, E4, E5, E6 and E7, and wherein the one or more substituent(s) X is $-NR_1R_2$ wherein $R_1$ and $R_2$ have the same meaning as described above.

The formulae below are representations of preferred triarylamines according to the preferred embodiment E8 :

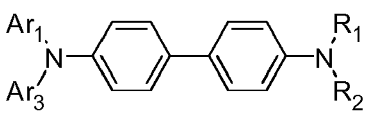

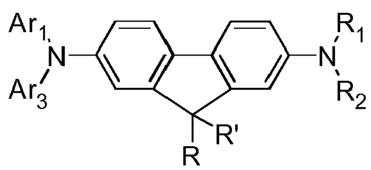

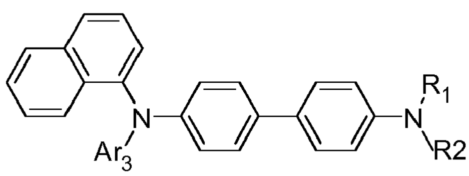

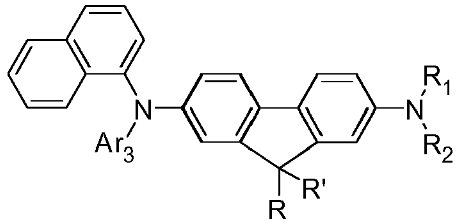

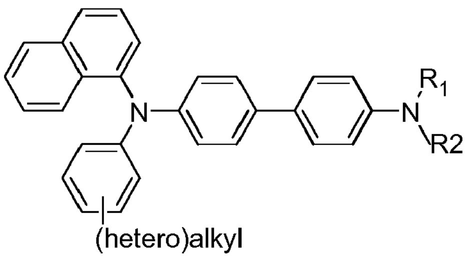

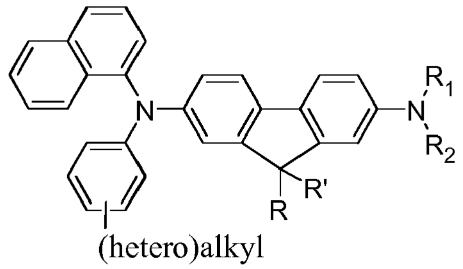

In accordance with embodiment E8, $R_1$ is an optionally substituted aryl or heteroaryl group, said aryl or heteroaryl group being preferably derived from a compound selected from benzene, naphthalene, anthracene, tetracene, phenanthrene, pyrene, 1H-phenalene, chrysene, triphenylene, benzo[pqr]tetraphene, coronene, benzofuran, benzothiophene, dibenzo[b,d]furan, dibenzo[b,d]thiophene, quinoline, quinoxaline, isoquinoline, 1,5-naphthyridine and 1,8-naphthyridine, more preferably selected from naphthalene, anthracene, phenanthrene and pyrene, even more preferably being naphthalene.

The authors have found that $R_1$ being 1-naphthyl group is particularly well adapted for the invention.

$R_2$ is advantageously an optionally substituted aryl or heteroaryl group, said aryl or heteroaryl group being derived from a compound preferably selected from benzene, naphthalene, anthracene, tetracene, phenanthrene, pyrene, 1H-phenalene, chrysene, triphenylene, benzo[pqr]tetraphene, coronene, benzofuran, benzothiophene, dibenzo[b,d]furan, dibenzo[b,d]thiophene, quinoline, quinoxaline, isoquinoline, 1,5-naphthyridine and 1,8-naphthyridine, more preferably selected from benzene, naphthalene, anthracene, phenanthrene and pyrene, even more preferably being benzene.

The authors have found that $R_2$ being a phenyl group substituted by $C_{1-20}$ alkyl or heteroalkyl group is particularly well adapted for the invention. The $C_{1-20}$ alkyl or heteroalkyl group may be linear, branched or cyclic.

Non exhaustive examples of triarylamines (hereinafter so-called "binders") particularly well suited to be used in the composition of the present invention are represented by formulae (I) to (XXVIII) below. Binders 1 to 4 represented below are even more particularly well suited to be used in the composition of the present invention.

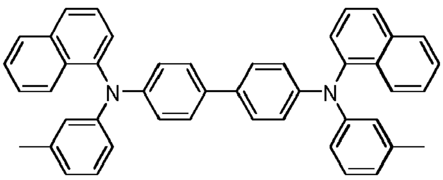

**(I)**

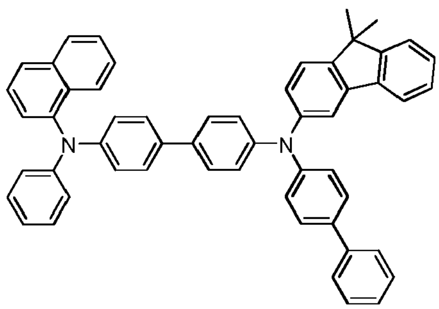

**(II)**

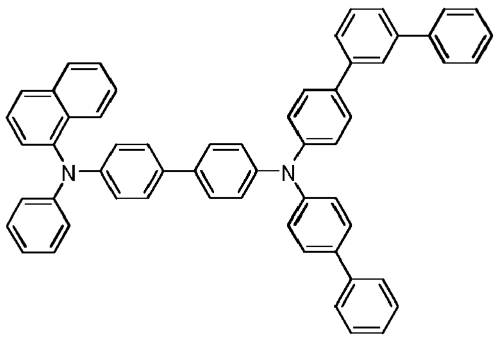
(III)

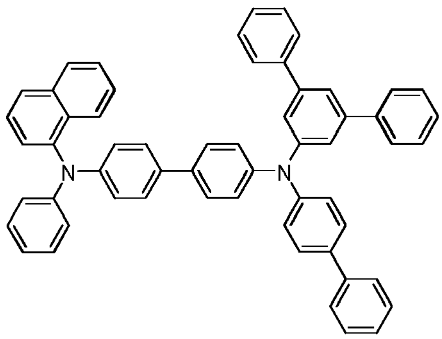
(IV)

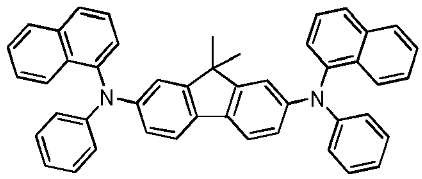
(V)

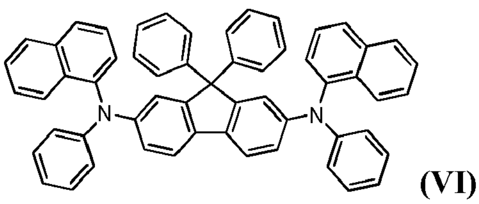
(VI)

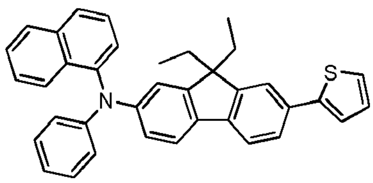
(VII)

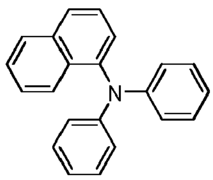
(VIII)

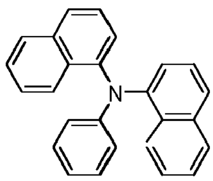
(IX)

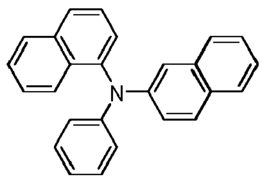
(X)

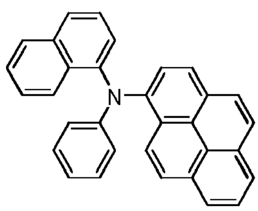
(XI)

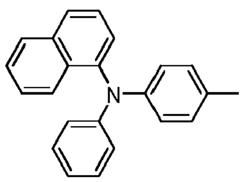
(XII)

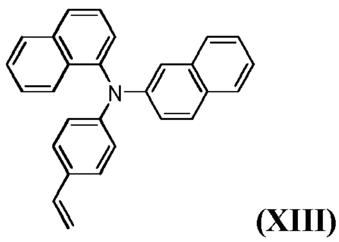
(XIII)

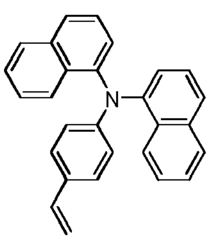
(XIV)

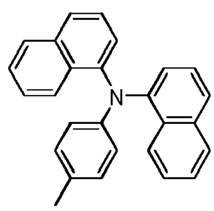
(XV)

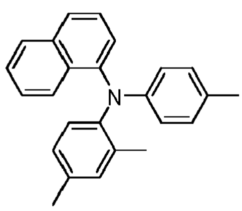
(XVI)

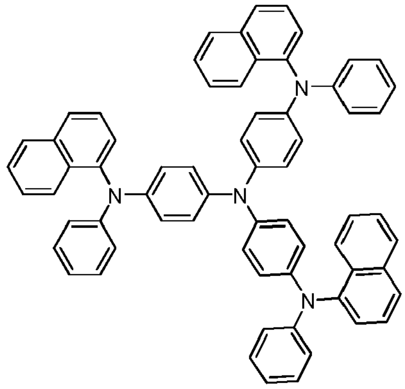

(XVII)

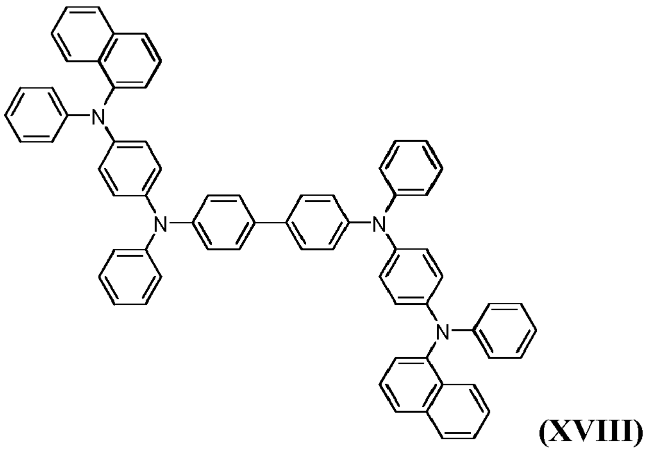

(XVIII)

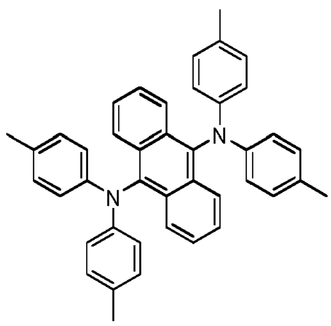

(XIX)

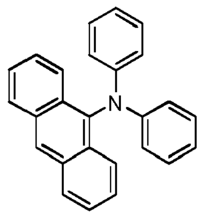

(XX)

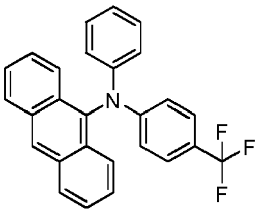

(XXI)

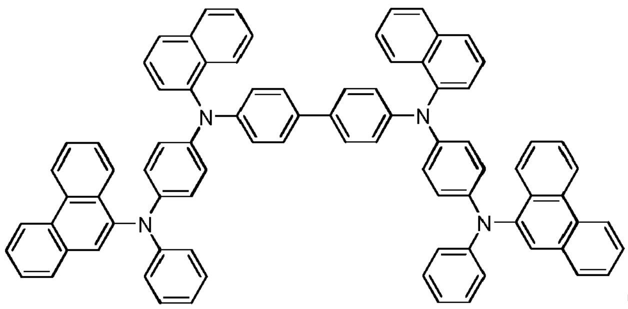

(XXII)

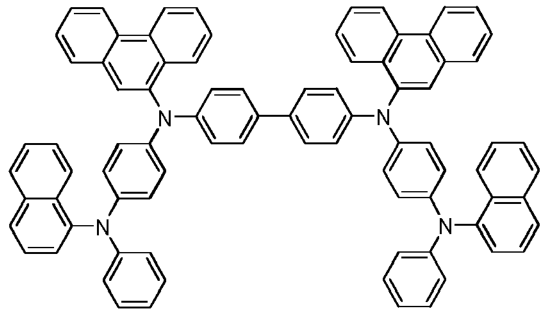

(XXIII)

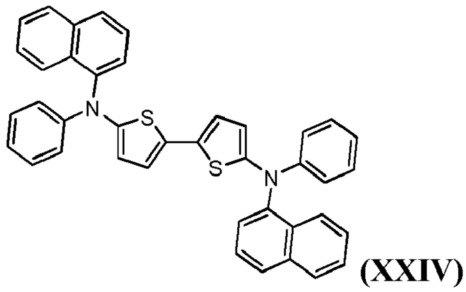

(XXIV)

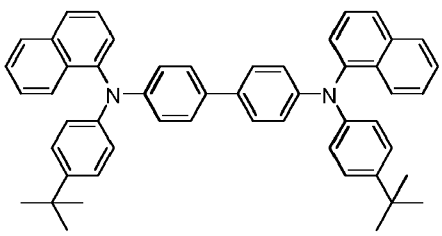

(XXV)Binder 1

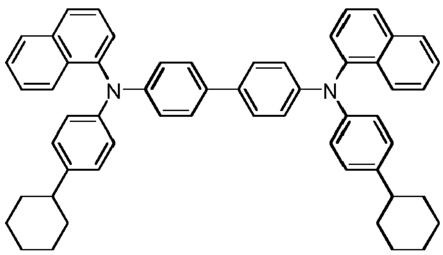

(XXVI) Binder 2

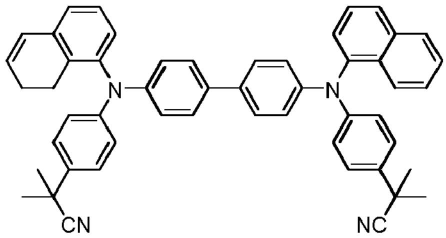

(XXVII) Binder 3

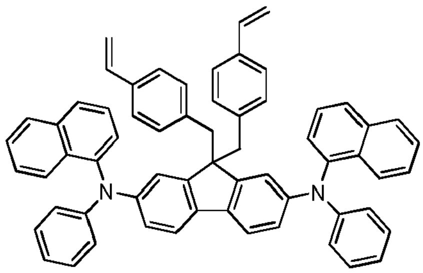

(XXVIII) Binder 4

The triarylamines used in the compositions according to the invention have a molecular weight of 1600 Daltons or less, preferably 1200 Daltons or less, more preferably 1000 Daltons or less, even more preferably 800 Daltons or less.

As a consequence of their relatively low molecular weight, the triarylamines can be advantageously purified by sublimation under vacuum. Moreover, they can also be purified by column chromatography onto silica or alumina gel using solvent or mixture of solvents as the eluent when their solubility in said solvent or mixture of solvent is exceeding 5 mg/ml, preferably 10 mg/ml, more preferably 20 mg/ml and most preferably 50 mg/ml.

The triarylamine in accordance with the invention is advantageously an amorphous material. It exhibits advantageously a glass transition temperature of at least 80°C, preferably of at least 100°C and even more preferably of at least 120°C.

It has been advantageous, in certain circumstances, that the triarylamine used in the compositions of the present invention have a HOMO level of less than -5.0 eV, preferably less than -5.2 eV and most preferably a HOMO level of less than -5.5 eV; besides it has a LUMO level of more than -3.5 eV, preferably more than -3.3 eV and most preferably more than -3.0 eV.

The composition in accordance with the invention comprises at least one crystalline organic semiconductor. By crystalline, is meant a compound that spontaneously self-organizes to give material which reveals a melting point that can be measured by any technique known by a person having ordinary skill in the art. For example, the presence of a melting point and its value can be determined by Differential Scanning Calorimetry. The crystalline organic semiconductor is chosen such that it exhibits a high tendency to crystallize when solution coating methods are used.

The crystalline semiconductor is preferably a small molecule which has a molecular weight of 1600 Daltons or less, preferably 1200 Daltons or less, more preferably 1000 Daltons or less, even more preferably 800 Daltons or less.

Preferred crystalline organic semiconducting materials which can be used in the present invention have a field effect mobility of at least 0.01 $cm^2/Vs$, preferably of at least 0.1 $cm^2/Vs$, more preferably of at least 1$cm^2/Vs$. The mobility referred to here is preferably determined in the saturation mode using a field effect transistor. In this technique, for each fixed gate voltage $V_{GS}$ the drain-source voltage $V_{DS}$ is increased until the current $I_0$ saturates. Next, the square root of this saturated current is plotted against the gate voltage and the slope $m_{sat}$ is measured. Then the mobility is

$$\mu = m_{sat}^2 \, 2L/WC_i \qquad \text{(Equation 1)}$$

where L and W are the length and width of the channel and $C_1$ is the gate insulator capacitance per unit area.

There is no limitation in the choice of the structure of the crystalline organic semiconductor that can be used in the present invention. The person skilled in the art can select the crystalline organic semiconductor based on his professional knowledge and based on some reviews on the subject. Crystalline organic semiconductors having suitable structures can be found in the review of Daoben Zhu et al. in Chemical Reviews, 2012, 112, 2208-2267 and more particularly in Table 2 of the said review.

Exemplary small molecule organic semiconductors are selected from compounds of formulae:

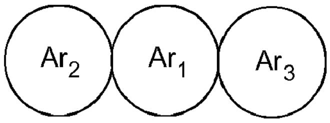

(1)

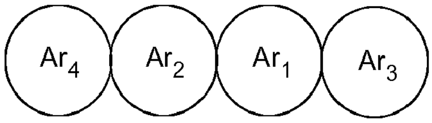

(2)

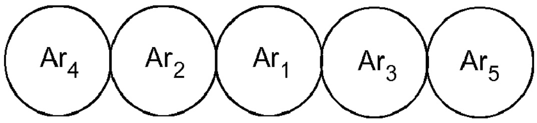

(3)

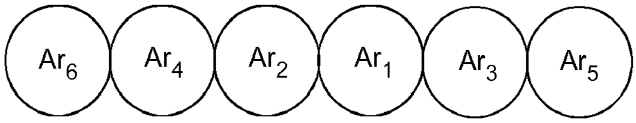

(4)

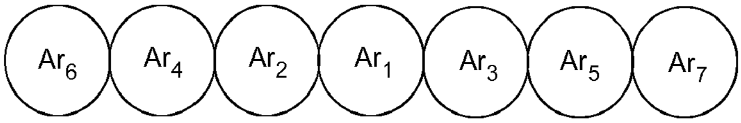

(5)

wherein $Ar_1$ to $Ar_7$ are the same or different at each occurrence and are each independently selected from the group consisting of monocyclic aromatic rings and monocyclic heteroaryl aromatic rings, with at least one of $Ar_1$ to $Ar_7$ being substituted with at least one substituent Z which may be the same or different at each occurrence and is selected from the group consisting of unsubstituted or substituted straight, branched or cyclic alkyl groups having from 1 to 50 carbon atoms, alkoxy groups having from 1 to 50 carbon atoms, aryloxy groups having from 6 to 40 carbon atoms, alkylaryloxy groups having from 7 to 40 carbon atoms, alkoxycarbonyl groups having from 2 to 40 carbon atoms, aryloxycarbonyl groups having from 7 to 40 carbon atoms, amino groups that may be unsubstituted or substituted with one or two alkyl groups having from 1 to 20 carbon atoms, each of which may be the same or different, amido groups, silyl groups that may be unsubstituted or substituted with one, two or three alkyl groups having from 1 to 20 carbon atoms, silylethinyl groups that may be unsubstituted or substituted with one, two or three alkyl groups having from 1 to 20 carbon atoms, alkenyl groups having from 2 to 20 carbon atoms, the carbamoyl group, the haloformyl group, the formyl group, the cyano group, the isocyano group, the isocyanate group, the thiocyanate group, the thioisocyanate group, OH, nitro, cyano, haloalkyl groups having 1 to 20 carbon atoms and wherein $Ar_1$, $Ar_2$ and $Ar_3$ may each optionally be fused to one or more further monocyclic aromatic or heteroaromatic rings.

In accordance with a preferred embodiment at least one of $Ar_1$ to $Ar_7$ comprises a 5 to 7 membered heteroaryl group containing from 1 to 3 sulfur atoms, oxygen atoms, selenium atoms and/or nitrogen atoms.

In a still further embodiment $Ar_1$ to $Ar_7$ are independently selected from phenyl and thiophene and at least one of $Ar_1$ to $Ar_7$ is thiophene.

A first group of small molecule organic semiconductors in accordance with the above general formulae which can be used in the compositions of the present invention are oligo-and polyacenes.

Acenes or polyacenes are a class of organic compounds and parties cyclic aromatic hydrocarbons made up of linearly fused benzene rings, i.e. having a skeleton of general formula

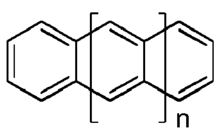

which may be substituted with substituents Z as defined above in any position. In preferred compounds of this group n is an integer in the range of from 1 to 4.

Pentacene compounds for which n is 3 and corresponding to formula **(3)** have been used in a number of applications for the manufacture of organic electronic devices. Exemplary representatives of suitable pentacene compounds are represented by formulae below:

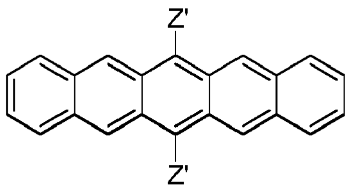

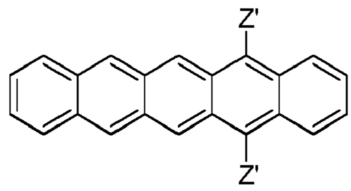

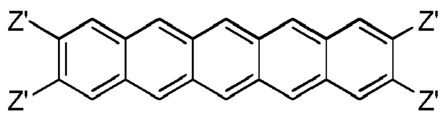

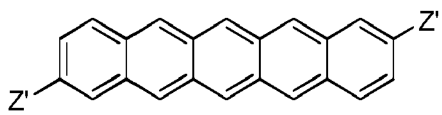

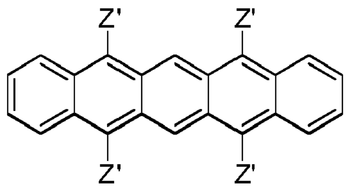

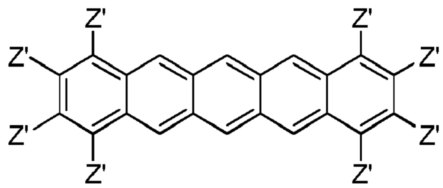

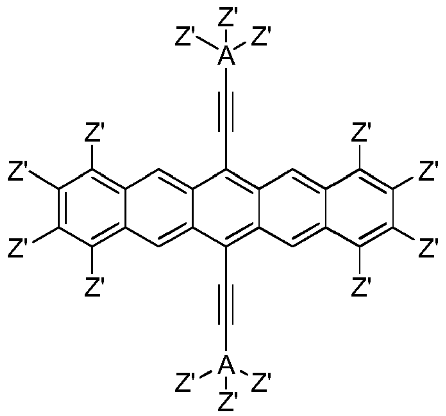

**(A)**

in which Z', which may be the same or different at each occurrence, is hydrogen or has a meaning as defined above for Z, with the proviso that at least one substituent Z' is different from hydrogen, and wherein A is carbon, silicon or germanium, preferably silicon or germanium. The substituents Z' at the atom A in this case are preferably alkyl groups or alkoxy groups having from 1 to 20, preferably from 1 to 12 and even more preferably 1 to 8 carbon atoms.

Still another group of compounds corresponding to formula (3) is represented by formula:

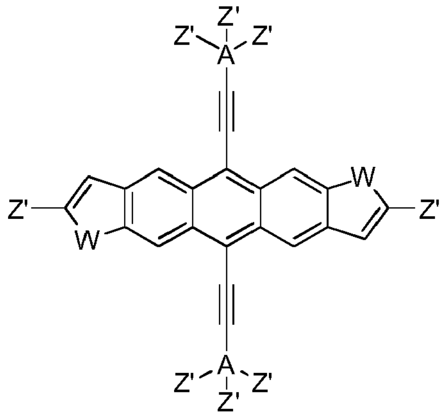

(B)

wherein Z' and A are as defined above and may be the same or different at each occurrence and wherein W is selected from the group consisting of S, NH, NZ' or Se, preferably from S or Se. The substituents Z' at the atom A in this case are preferably alkyl groups or alkoxy groups having from 1 to 20, more preferably from 1 to 12 and even more preferably from 1 to 8 carbon atoms and the substituent Z' in NZ' is an alkyl group having from 1 to 12, more preferably from 1 to 8 carbon atoms.

Another group of compounds, of general formula **(2)**, preferred as organic semiconductors in the present invention are compounds of general formula:

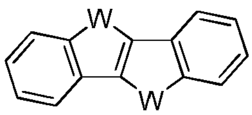

(C)

wherein W is as defined above and which may bear substituents Z' as defined above at any of the carbon atoms of the ring system.

Another group of compounds, of general formula **(4)**, preferred as organic semiconductors in the present invention are compounds of general formula:

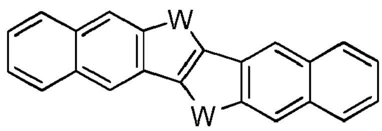

(D)

wherein W is as defined above and which may bear substituents Z' as defined above at any of the carbon atoms of the ring system.

Another group of compounds, of general formula **(5)**, preferred as organic semiconductors in the present invention are compounds of general formula

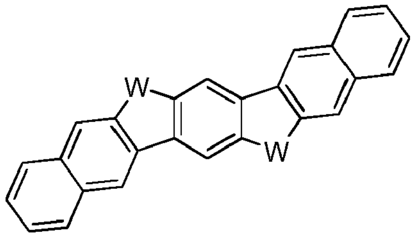

(E)

wherein W is as defined above and which may bear substituents Z' as defined above at any of the carbon atoms of the ring system.

Still another group of preferred organic semiconductors in the compositions of the present invention and corresponding to formula **(3)** are furan or thiophene V-shaped organic semiconducting materials of general formula

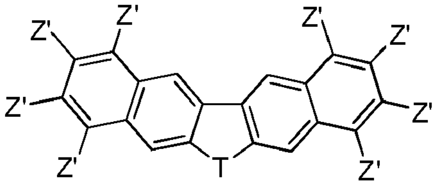

wherein T is an oxygen or a sulfur atom and Z', which may be the same or different at each occurrence, may have the meaning as defined above.

Representative examples are:

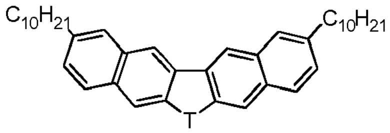

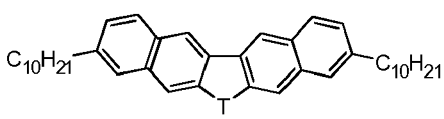

wherein T is preferably sulfur.

Compounds of this structure as well as their synthesis have been described in Adv.Mater. 2013, 25, 6392-6397 and Chem. Comm. 2014, 50, 5342-5344 to which reference is made for further details.

Still another group of preferred organic semiconductors in the compositions of the present invention and corresponding to formula **(1)** is V-shaped organic semiconducting materials of general formula

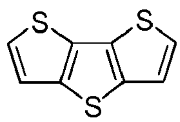

which may bear substituents Z' as defined above at any of the carbon atoms of the ring system.

Representative examples are

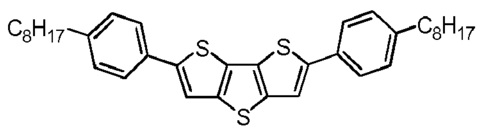

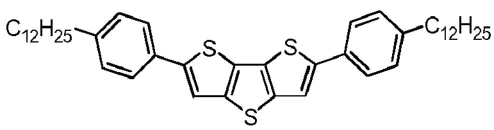

Compounds of this structure as well as their synthesis have been described in Chem. Comm. 2013, 49, 6483-6485 to which reference is made for further details.

Particularly preferred examples for compounds of formula **(A)** are the compounds of formulae below which are generally known under the names given next to the formula

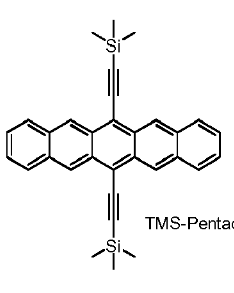

TMS-Pentacene

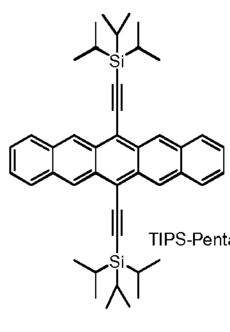

TIPS-Pentacene

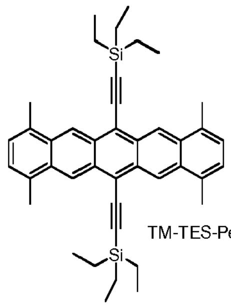

TM-TES-Pentacene

**(OS1)**

A preferred organic semiconductor corresponding to a general formula **(B)** is represented by formula

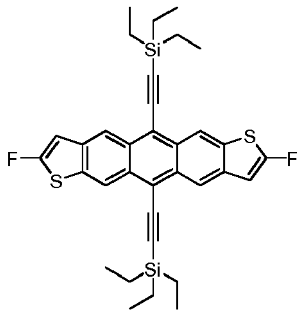

diF-TES-ADT

Particularly preferred representatives of general formula **(C)** are benzothieno benzothiophene derivatives represented by general formula below

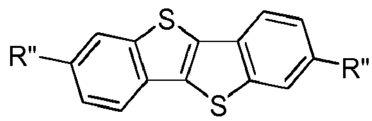

wherein R", which may be the same or different, represents an alkyl group having 1 to 30, preferably from 1 to 20 and most preferably from 1 to 12 carbon atoms. A particularly preferred compound of this group is known as C8-BTBT in which both substituents R" are n-$C_8H_{17}$ (n-octyl) groups.

Particularly preferred representative of general formula **(D)** is Dinaphtothienothiophene derivative represented by general formula below

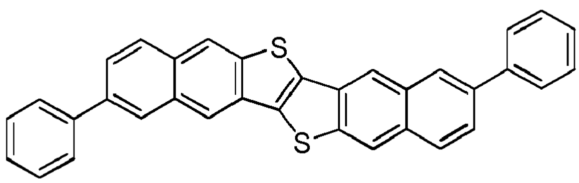

Particularly preferred representatives of general formula (E) are derivatives represented by general formula below

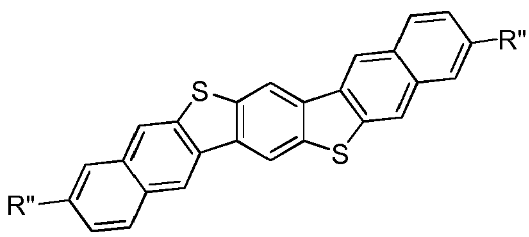

wherein R", which may be the same or different, represents an alkyl group having 1 to 30, preferably from 1 to 20 and most preferably from 1 to 12 carbon atoms. A particularly preferred compound of this group is known as C10-DNBDT in which both substituents R" are n-$C_{10}H_{21}$ groups.

In the composition according to the invention, the weight ratio of crystalline organic semiconductor to triarylamine is comprised from 5/95 to 95/5, preferably from 25/75 to 75/25, more preferably from 34/66 to 66/34.

The composition according to the invention may be available in the form of an ink, i.e. it further comprises at least one organic solvent, which form makes it easily deposited onto a substrate.

In such case the combined content of the triarylamine and of the crystalline organic semiconductor versus the total weight of the composition (i.e. including, inter alia, the organic solvent) is of at least 0.5 wt. %, preferably of at least 1 wt. % and more preferably of at least 1.5 wt. %; besides, the combined content of the triarylamine and of the crystalline organic semiconductor versus the total weight of the composition (i.e. including, inter alia, the organic solvent) is of at most 10 wt. %, preferably of at most 5 wt. % and more preferably of at most 3 wt. %, with regard to the total weigh of the composition.

In particular embodiments, the composition is coated onto a substrate by vacuum deposition. Then, it is advantageously free of solvent. Besides, when the composition according to the invention is available in the form of an ink, the solvent comprised in the ink is advantageously removed from the composition after the ink is deposited on the substrate, thereby obtaining advantageously a composition essentially free or even completely free of solvent.

Thus, in the invented composition, an organic solvent may be present or not.

In any case, the weight content of triarylamine is generally of at least 5 wt. % with regard to the total weight of the composition diminished by the weight of the organic solvent, whatever present or not. It is preferably of at least 25 wt. %, more preferably of at least 35 wt. %, even more preferably of at least 50 wt. % with regard to the total weight of the composition diminished by the weight of the organic solvent. Besides, the weight content of triarylamine is generally of at most 95 wt. % with regard to the total weight of the composition diminished by the weight of the organic solvent; it is preferably of at most 85 wt. %, more preferably of at most 75 wt. %, even more preferably of at most 65 wt. % with regard to the total weight of the composition diminished by the weight of the organic solvent.

The viscosity of the solvents preferably is in the range of from 0.2 to 50 mPas, preferably in the range of from 1 to 20 mPas, measured at 25°C.

The Hansen solubility parameters of the solvent used, expressed in $MPa^{1/2}$, are preferably within the following ranges:

Hd: 15 to 25, preferably 17 to 23
Hp: 0 to 20, preferably 0 to 15
Hh: 0 to 25, preferably 0 to 20

wherein Hd, Hp and Hh respectively represent the dispersive, the polar and the hydrogen bonding solubility parameters.

The solvent surface tension in mN/m (at 20°C) is preferably in the range of from 10 to 70, more preferably in the range of from 20 to 50 and most preferably in the range of from 26 to 38.

Examples of suitable and preferred organic solvents include, without being limited to, dichloromethane, trichloromethane, monochlorobenzene, o-dichlorobenzene, the respective bromobenzenes, tetrahydrofuran, anisole, morpholine, toluene, o-xylene, m-xylene, p-xylene, the isomeric trimethylbenzenes, in particular 1,3,5 trimethylbenzene (also known as mesitylene), 1,4-dioxane, acetone, 1,1,2,2-tetrachloroethane, ethyl acetate, n-butyl acetate, dimethylformamide, dimethylacetamide, dimethylsulfoxide, tetralin (tetrahydronaphthalene), halogenated naphthalenes, such as 1-bromo naphthalene, decalin, indane and/or mixtures thereof.

Especially preferred solvents for use in the compositions according to the present invention are anisole, the isomeric xylenes, toluene, mesitylene, tetralin, chlorobenzene, bromobenzene, o-dichlorobenzene and 1-bromonaphthalin and/or mixtures thereof.

Even more preferred solvents are anisole and tetralin.

The preferred solvents have a boiling point in the range of from 80 to 350, preferably of from 100 to 300 and even more preferably of from 130 to 230°C.

The composition in accordance with the present invention can additionally comprise one or more further components like e.g. surface-active compounds, lubricating agents, wetting agents, dispersing agents, hydrophobic agents, adhesive agents, flow improvers, defoaming agents, deaerators, diluents (reactive or non-reactive), auxiliaries, colorants, dyes, pigments or nanoparticles.

It is also the object of the present invention to disclose the use of the composition in accordance with the present invention for the manufacture of a semiconducting layer.

The semiconducting layer obtained through the use of the composition in accordance with the present invention is typically at most 1 μm thick, preferably at most 500 nm although greater thicknesses may be achieved if required. The semiconducting layer obtained is typically at least 10 nm thick, preferably at least 50 nm.

The present invention also relates to a process for the manufacture of an organic semiconducting layer comprising applying the composition as above described to form a layer onto a substrate.

Preferably, in the invented process, the composition additionally comprises at least one organic solvent and the process further comprises evaporating the solvent from the layer.

Indeed, to form a layer onto a substrate, especially a thin layer, liquid coating of organic semiconductor composition is generally preferred over vacuum deposition which is possible anyway. The composition in accordance with the present invention enables the use of numbers of liquid coating techniques.

Just by way of example dip coating, spin coating, slot die coating, inkjet printing, letter-press printing, screen printing, doctor blade coating, roller printing, reverse roller-printing, offset lithography printing, flexographic printing, flexographic coating, spray coating, brush coating or pad printing may be mentioned here.

The inkjet fluid (i.e. the mixture of semiconducting compounds, binder and solvent) preferably has a viscosity at 20°C of 1-100 mPas, more preferably of 1-50 mPas and most preferably 1-30 mPas.

A substrate used for preparing the organic semiconducting layer may include any underlying device layer, electrode or separate substrate such as e.g. silicon wafer, glass or polymer substrate.

The present invention furthermore relates to an organic electronic device comprising an organic semiconducting layer in accordance with the invention. The electronic device generally comprises a gate electrode, a source electrode and a drain electrode, said device further comprises an organic semiconducting layer between the source and drain electrode, which organic semiconducting layer is obtained using the composition in accordance with the present invention.

Preferred organic electronic devices are organic field effect transistors.

The present invention finally relates to an electronic device comprising an organic field effect transistor comprising a semiconducting layer obtained using the composition in accordance with the invention.

The said electronic device is generally a display, more preferably an active matrix display, even more preferably an active matrix OLED display.

The following examples provide further information on the preferred embodiments of the present invention.

## Examples

Organic Thin Film Transistors (OTFTs) were fabricated in top gate and bottom contact configuration using glass based substrates as detailed hereinafter.

1" square glass substrates (ex: Corning XG) were cleaned using sonication bathes for 5 minutes in Deconex (3% in water) followed by rinsing in ultrapure water and dried using compressed air. A planarization layer was first spin coated on top of the cleaned substrates in order to create a 30 nm film after photocrosslinking. Au (30 nm) bottom contact source/drain (S/D) electrodes were deposited on top of the planarization layer by thermal evaporation through a shadow mask. The 16 transistors S/D consisted of electrodes with channel length of 50μm and channel width of 0.5mm. The substrates then underwent UV/$O_3$ treatment (model 42-220, from Jelight Company, Inc.), treatment time 5min. Prior to spin coating of the OSC solution, a 10mM solution of 4-fluorobenzenethiol in 2-propanol was applied to the surface of the electrodes for 1 minute followed by spin coating and rinsing by fresh 2-propanol, followed by drying on a hotplate at 100 °C. The organic semiconductor (OSC) formulation was spin coated onto the SD electrodes using a Laurell spinner set at 1500 rpm followed by baking on a hotplate for 60 seconds at 100°C. Hyflon® AD SF 9.2% w/w solution commercialized by Solvay Specialty Polymers was spin coated at 3000 rpm and the samples were baked on a hotplate for 60s at 100°C. Gate electrodes were defined by evaporation of Aluminum (60nm) through a shadow mask in a thermal evaporator system.

## OTFT characterization

OTFTs were tested using a Cascade Microtech EP6 DC probe station in conjunction with an Agilent B1500A semiconductor parameter analyzer. The Agilent system calculated the linear mobility according to the equation shown below (Equation 2)

$$\mu_{Lin} = \frac{\partial I_{DS}}{\partial V_G} \frac{L}{W C_i V_{DS}} \qquad \text{(Equation 2)}$$

where L is the transistor length, W is the transistor width and $C_i$ is the dielectric capacitance per unit area. $V_{DS}$ was set at -4V unless otherwise stated. The mobility values reported are an average of the 5 highest points in accumulation for each transistor. The standard deviation of the mobility values is reported as a percentage of the mean.

**Comparative Example 1:** 1,4,8,11-tetramethyl-6,13-Triethylsilylethynylpentacene without triarylamine binder; TG OTFT

The OTFT array fabricated and characterized as the comparative example 1 was fabricated and tested as described above. The formulation tested in the comparative example 1 included small molecule semiconductor however this formulation did not incorporate any triarylamine binder.
1,4,8,11-tetramethyl-6,13-triethylsilylethynylpentacene represented by formula **(OS1)** was formulated in tetralin at 1.5% by weight total solids content. This was coated as an OSC layer in an OTFT device according to the method shown above for glass substrate.
The TFT performance of this formulation is shown below: **$\mu$ Lin = 1.8$\pm$0.8 $cm^2/Vs$; standard deviation as a % of the mean value of the mobility was 44.4 %.**
The OTFT array fabricated and characterized as the comparative example 2 was fabricated and tested as described above. The formulation tested in the comparative example 2 included a small molecule semiconductor and a triarylamine polymer as binder.

**Comparative Example 2:** 1,4,8,11-tetramethyl-6,13-Triethylsilylethynylpentacene with triarylamine polymer binder; TG OTFT

1,4,8,11-tetramethyl-6,13-triethylsilylethynylpentacene represented by formula **(OS1)** and Poly[bis(4-phenyl)(2,4,6-trimethylphenyl)amine] were formulated in tetralin in a ratio 50:50 at total solids content of 2% by weight. This was coated as an OSC layer in an OTFT device according to the method shown above for glass substrate.
The TFT performance of this formulation is shown below: **$\mu$ Lin = 3.8$\pm$1.1 $cm^2/Vs$; standard deviation as a % of the mean value of the mobility was 28.9 %.**

**Examples 1 to 6**

The OTFT arrays fabricated and characterized as the examples 1 to 6 were fabricated and tested as described above. The formulations tested in the examples 1 to 6 included small molecule semiconductor and an amorphous small-molecule triarylamine as binder. In these examples the ratio of binder to the semiconductor is in parts by weight.

**Example 1 :** 1,4,8,11-tetramethyl-6,13-Triethylsilylethynylpentacene with small-molecule triarylamine binder; TG OTFT

N4,N4'-bis(4-cyclohexylphenyl)-N4,N4'-di(naphthalen-1-yl)biphenyl-4,4'-diamine **(Binder 2)**, was formulated with 1,4,8,11-tetramethyl-6,13-triethylsilylethynyl pentacene represented by formula **(OS1)** in a ratio 60:40 at a total solids content of 1.5% by weight in tetralin and coated as an OSC layer in an OTFT device according to the method shown above for glass substrate devices.
The TFT performance of this formulation is shown below: **$\mu$ Lin = 4.9$\pm$0.4 $cm^2/Vs$; standard deviation as a % of the mean value of the mobility was 8.1 %.**

**Example 2 :** 1,4,8,11-tetramethyl-6,13-Triethylsilylethynylpentacene with small-molecule triarylamine binder; TG OTFT

N2,N7-di(naphthalen-1-yl)-N2,N7-diphenyl-9,9-bis(4-vinylbenzyl)-9H-fluorene-2,7-diamine **(Binder 4)**, was formulated with 1,4,8,11-tetramethyl-6,13-Triethylsilylethynylpentacene represented by formula **(OS1)** in a ratio 60:40 at a total solids content of 1.5% by weight in tetralin and coated as an OSC layer in an OTFT device according to the method shown above for glass substrate devices.
The TFT performance of this formulation is shown below: **$\mu$ Lin = 5.1$\pm$0.5 $cm^2/Vs$; standard deviation as a % of the mean value of the mobility was 9.8 %.**

**Example 3 :** 1,4,8,11-tetramethyl-6,13-Triethylsilylethynylpentacene with small-molecule triarylamine binder; TG OTFT

2,2'-(4,4'-(biphenyl-4,4'-diylbis(naphthalen-1-ylazanediyl))bis(4,1-phenylene))bis(2-methylpropanenitrile) **(Binder 3)**, was formulated with 1,4,8,11-tetramethyl-6,13-Triethylsilylethynylpentacene represented by formula **(OS1)** in a ratio 60:40 at a total solids content of 1% by weight in tetralin and coated as an OSC layer in an OTFT device according to the method shown above for glass substrate devices.
The TFT performance of this formulation is shown below: **$\mu$ Lin = 5.0$\pm$0.4 $cm^2/Vs$; standard deviation as a % of the mean value of the mobility was 8.0 %.**

**Example 4 :** 1,4,8,11-tetramethyl-6,13-Triethylsilylethynylpentacene with small-molecule triarylamine binder; TG OTFT

2,2'-(4,4'-(biphenyl-4,4'-diylbis(naphthalen-1-ylazanediyl))bis(4,1-phenylene))bis(2-methylpropanenitrile) **(Binder 3)**, was formulated with 1,4,8,11-tetramethyl-6,13-Triethylsilylethynylpentacene represented by formula **(OS1)** in a ratio 60:40 at a total solids content of 1% by weight in anisole and coated as an OSC layer in an OTFT device according to the method shown above for glass substrate devices.
The TFT performance of this formulation is shown below: $\mu$ **Lin = 4.7±1.5 cm$^2$/Vs; standard deviation as a % of the mean value of the mobility was 31.9 %.**

**Example 5 :** 1,4,8,11-tetramethyl-6,13-Triethylsilylethynylpentacene with small-molecule triarylamine binder; TG OTFT

N4,N4'-bis(4-cyclohexylphenyl)-N4,N4'-di(naphthalen-1-yl)biphenyl-4,4'-diamine **(Binder 2)**, was formulated with 1,4,8,11-tetramethyl-6,13-Triethylsilylethynylpentacene represented by formula **(OS1)** in a ratio 60:40 at a total solids content of 1% by weight in anisole and coated as an OSC layer in an OTFT device according to the method shown above for glass substrate devices.
The TFT performance of this formulation is shown below: $\mu$ **Lin = 9.7±1.7 cm$^2$/Vs; standard deviation as a % of the mean value of the mobility was 17.5 %.**

**Example 6 :** 1,4,8,11-tetramethyl-6,13-Triethylsilylethynylpentacene with small-molecule triarylamine binder; TG OTFT

N4,N4'-bis(4-tert-butylphenyl)-N4,N4'-di(naphthalen-1-yl)biphenyl-4,4'-diamine **(Binder 1)**, was formulated with 1,4,8,11-tetramethyl-6,13-Triethylsilylethynylpentacene represented by formula **(OS1)** in a ratio 60:40 at a total solids content of 1% by weight in anisole and coated as an OSC layer in an OTFT device according to the method shown above for glass substrate devices.
The TFT performance of this formulation is shown below: $\mu$ **Lin = 9.3±1.2 cm$^2$/Vs; standard deviation as a % of the mean value of the mobility was 12.9 %.**
The previous examples show that the composition in accordance with the present invention, comprising an organic semiconductor and a small molecule triarylamine binder yielded OTFTs with improved performance compared to OTFTs obtained using compositions in accordance with the prior art. More particularly, measured linear mobility values were high, the standard deviation of the mobility values was low and the bias stress stability was improved.

## Claims

**1.** Composition comprising at least one crystalline organic semiconductor and at least one triarylamine of formula 1

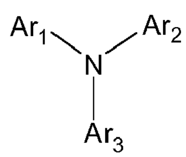

1

wherein

each of $Ar_1$, $Ar_2$ and $Ar_3$ independently represents an optionally substituted aryl or an optionally substituted heteroaryl group,
provided at least one of $Ar_1$, $Ar_2$ and $Ar_3$ comprises at least two fused aromatic or heteroaromatic rings.

**2.** Composition according to claim 1 wherein the triarylamine has a molecular weight of 1600 Daltons or less.

**3.** Composition according to claim 1 or 2 wherein the crystalline semiconductor has a field effect mobility of at least 0.01 cm$^2$/Vs.

**4.** Composition according to any one of the preceding claims wherein the weight ratio of crystalline organic semiconductor to triarylamine is comprised from 5/95 to 95/5.

**5.** Composition according to any one of the preceding claims which is essentially free of solvent.

**6.** Composition according to any one of the preceding claims but 5 additionally comprising at least one organic solvent.

**7.** Use of the composition according to any one of claims 1 to 6 for the manufacture of a semiconducting layer.

**8.** Process for the manufacture of an organic semiconducting layer comprising applying the composition according to any one of claims 1 to 6 to form a layer onto a substrate.

**9.** Process according to claim 8, wherein the composition is the composition according to claim 6 and the process further comprises evaporating the solvent from the layer.

**10.** Device comprising the composition according to any one of claims 1 to 5 or the organic semiconducting layer manufactured by the process according to claim 8 or 9.

**11.** Device according to claim 10, which is or comprises a field effect transistor.

**12.** Device according to claim 11, which is a field effect transistor.

**13.** Display comprising the device according to claim 12.

Europäisches Patentamt
European Patent Office
Office européen des brevets

# EUROPEAN SEARCH REPORT

Application Number
EP 16 17 4446

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YI LI ET AL: "White organic light-emitting diodes based on doped and ultrathin Rubrene layer", OPTICAL SENSING II, vol. 7658, 13 May 2010 (2010-05-13), page 76583L, XP55323172, 1000 20th St. Bellingham WA 98225-6705 USA ISSN: 0277-786X, DOI: 10.1117/12.866730 ISBN: 978-1-62841-971-9 | 1,2,5,7, 8,10 | INV. H01L51/05 |
| A | * the whole document * | 3,4,6,9, 11-13 | |
| | ----- | | |
| X | SHENGWEI SHI ET AL: "A pentacene-doped hole injection layer for organic light-emitting diodes; A pentacene-doped hole injection layer for organic light-emitting diodes", SEMICONDUCTOR SCIENCE AND TECHNOLOGY, IOP PUBLISHING LTD, GB, vol. 20, no. 12, 1 December 2005 (2005-12-01), pages 1213-1216, XP020086408, ISSN: 0268-1242, DOI: 10.1088/0268-1242/20/12/012 | 1,2,4,5, 7,10 | |
| A | * the whole document * | 3,6,8,9, 11-13 | TECHNICAL FIELDS SEARCHED (IPC) |
| | | | H01L |
| | ----- | | |
| X | EP 1 148 109 A2 (TDK CORP [JP]) 24 October 2001 (2001-10-24) | 1,4,5,7, 8,10 | |
| A | * claim 1 * | 2,3,6,9, 11-13 | |
| | ----- | | |

The present search report has been drawn up for all claims

1

| Place of search | Date of completion of the search | Examiner |
|---|---|---|
| The Hague | 25 November 2016 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 16 17 4446

This annex lists the patent family members relating to the patent documents cited in the above-mentioned European search report. The members are as contained in the European Patent Office EDP file on
The European Patent Office is in no way liable for these particulars which are merely given for the purpose of information.

25-11-2016

| Patent document cited in search report | Publication date | Patent family member(s) | Publication date |
|---|---|---|---|
| EP 1148109 A2 | 24-10-2001 | EP 1148109 A2 | 24-10-2001 |
| | | EP 2262025 A2 | 15-12-2010 |
| | | JP 4024009 B2 | 19-12-2007 |
| | | JP 2002008867 A | 11-01-2002 |
| | | KR 20010099713 A | 09-11-2001 |
| | | TW 508971 B | 01-11-2002 |
| | | US 2003027016 A1 | 06-02-2003 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2009302310 A
- WO 2014008971 A


### Non-patent literature cited in the description


- **DAOBEN ZHU et al.** *Chemical Reviews,* 2012, vol. 112, 2208-2267
- *Adv.Mater.,* 2013, vol. 25, 6392-6397
- *Chem. Comm.,* 2014, vol. 50, 5342-5344
- *Chem. Comm.,* 2013, vol. 49, 6483-6485